# EUROPEAN PATENT APPLICATION

(11) **EP 1 501 128 A1**
(43) Date of publication of application: **26.01.2005**
(21) Application number: 03425494.6
(22) Date of filing: 23.07.2003
(51) Int. Cl.: H01L 27/115, H01L 21/8246

(54) **Three - dimensional ferro-electric memory cell and manufacturing process thereof**

(71) Applicant: STMicroelectronics S.r.l., 20041 Agrate Brianza (Milano) (IT)
(72) Inventor: Artoni, Cesare, 96011 Augusta (IT)
(74) Representative: Cerbaro, Elena, Dr.

(57) **Abstract**

A ferro-electric memory cell includes: a ferro-electric capacitor (80), having a first electrode (72a) and a second electrode (75a), and a ferro-electric region (73a) arranged between the first electrode (72a) and the second electrode (75a); and a selector (51), associated to the ferro-electric capacitor (80) and having conduction regions (62, 63), formed in an active area (53) of a semiconductor body (50), and a control region (58c), raised with respect to the conduction regions (62, 63). The ferro-electric capacitor (80) is arranged adjacent to at least one side (58a, 58b) of the control region (58c).

## Description

The present invention relates to a three-dimensional ferro-electric memory cell and to a manufacturing process thereof.

As is known, ferro-electric storage devices are normally based upon arrays of cells, each of which comprises a capacitor and a selector, for example an NMOS transistor, for selecting the capacitor when it is necessary to carry out read/write operations. The capacitor, which constitutes the memory element proper, is provided with a first and a second plate separated from one another by a layer of ferro-electric material. By applying appropriate voltages to the plates of the capacitor, it is possible to read or else modify the state of polarization of the ferro-electric material.

There have been proposed different architectures of ferro-electric memory cells, both of a planar type and of a three-dimensional type.

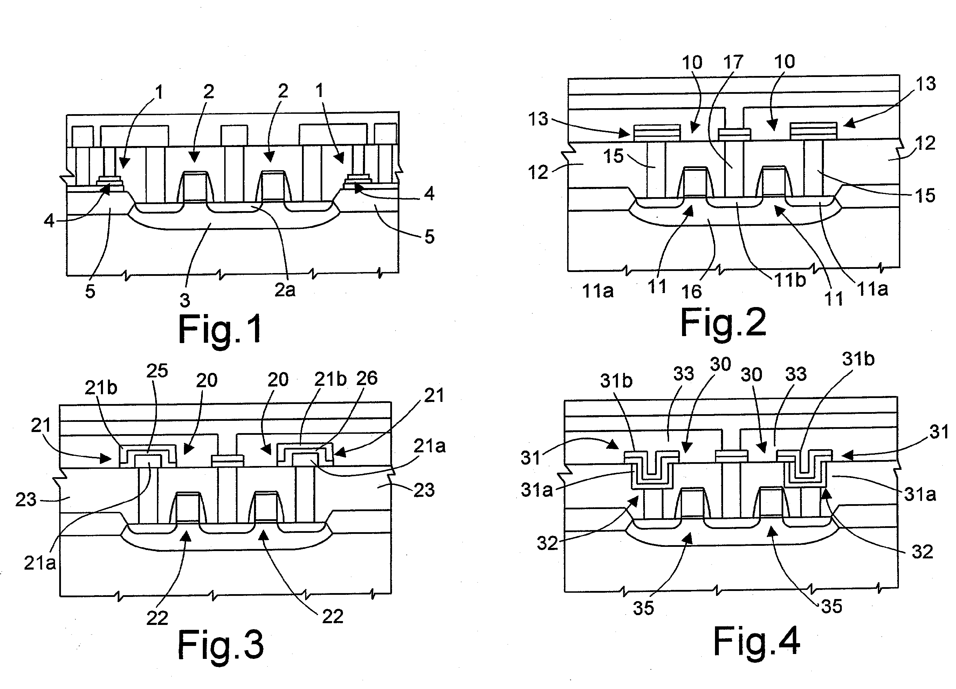

A first solution, illustrated in Figure 1, where ferro-electric memory cells are designated by the reference number 1, envisages making selectors 2 within respective semiconductor active areas 3 and ferro-electric capacitors 4 (i.e., having a layer of dielectric material arranged between the plates) on dielectric regions 5 separating laterally adjacent active areas 3. Furthermore, the cells 1 are arranged in pairs alongside one another, and the selectors 2 of one pair of cells 1, made in a same active area 3, share a same source region 2a. It is evident that, although sharing the source regions 2a, the cells 1 disadvantageously occupy a wide area, since the capacitors 4 and the respective selectors 2 are arranged alongside one another.

To improve occupation of area, it has hence been proposed to make stacked cells, as illustrated in Figure 2. In particular, a stacked cell comprises a selector 11 (here an NMOS transistor), coated with a dielectric layer 12, and a ferro-electric capacitor 13, made on the dielectric layer 12. More precisely, the capacitor 13 is located on top of a drain region 11a of the selector 11 and is electrically connected thereto by means of a through connection 15 across the dielectric layer 12. Also in this case, the selectors 11 associated to pairs of adjacent cells 10 are made in the same active area 16 and share the same source region 11b. The cells 10 thus made are compact, since the capacitor 13 is in part stacked on top of the selector 11, instead of being arranged alongside, but involve a complex fabrication process with a relatively low yield. In fact, before making the capacitor 13, it is necessary to: deposit and planarize the dielectric layer 12, typically via a chemical-mechanical-polishing (CMP) process; open trenches through the dielectric layer 12 by means of a masked etch and fill them with a metal, for example tungsten, for making the connections 15 and further contacts 17 for the source regions 11b; and remove the tungsten in excess by means of a further CMP process. In practice, between the fabrication steps of the selectors 11 and of the capacitors 13 approximately eight further processing steps must be envisaged. The process also involves other drawbacks. On the one hand, the large number of processing steps entails greater difficulties of alignment and, clearly, a higher probability of errors. On the other hand, making the contacts 16 for the source regions 11b before the capacitors 13 is critical. In fact, the ferro-electric material used in the capacitors 13, which after its deposition is initially amorphous, requires a recrystallization step in oxygen at high temperature (annealing).

The oxygen, however, tends to diffuse also within the silicon and the tungsten and can oxidize the contacts 15, rendering them unusable. Further processing steps must hence be envisaged for the purpose of protecting the contacts 15.

According to other known solutions, illustrated in Figures 3 and 4, three-dimensional capacitors are provided which, given the same area occupied, have greater surface and capacitance than planar capacitors. In particular, in the solution of Figure 3, a cell 20 comprises a ferro-electric capacitor 21, located on top of a selector 2 and separated therefrom by means of a dielectric layer 23. The capacitor 21 has a first plate 21a, which is basically plane, and a ferro-electric layer 25 and a second plate 21b, which are so shaped as to surround the first plate 21a on top and on the sides: in this way, the total capacitance of the capacitor 21 comprises also a contribution due to the side coupling between the plates 21a, 21b. Alternatively (Figure 4), a ferro-electric capacitor 31 of a cell 30 is arranged within a cavity 32 formed in a dielectric layer 33, on top of a selector 35. The capacitor 31 has plates 31a, 31b, which are basically cup-shaped and concentric; consequently, also in this case the capacitor 31 is three-dimensional and its capacitance is due also to the side coupling between the plates 31a, 31b. Also the solutions of Figures 3 and 4, however, suffer from the limitations already described as regards the cell 20 of Figure 2; in particular, they entail complex and costly processes of fabrication, which moreover involve some critical steps and consequently do not have an optimal yield.

The purpose of the present invention is to provide a ferro-electric memory cell and a corresponding fabrication process which will be free from the drawbacks described above.

According to the present invention a ferro-electric memory cell and a manufacturing process thereof are provided, as defined in Claim 1 and Claim 14, respectively.

For a better understanding of the invention, an embodiment thereof will be hereinafter described, purely by way of nonlimiting example, with reference to the attached drawings, in which:
- Figures 1-4 are cross-sectional views through respective ferro-electric memory cells of a known type;
- Figure 5 is a top plan view of a semiconductor wafer in an initial step of a manufacturing process according to the present invention;
- Figures 6 and 7 are cross-sectional views through the wafer of Figure 5, taken along the line VI-VI and the line VII-VII of Figure 5, respectively;
- Figure 8 shows the same view as that of Figure 6, in a subsequent processing step;
- Figure 9 shows an enlarged detail of Figure 8;
- Figure 10 shows the same view as that of Figure 8, in a subsequent processing step;
- Figure 11 is a cross-sectional view of the wafer of Figure 10, taken along the line XI-XI of Figure 10;
- Figures 12, 13 and 15 show the wafer of Figure 10, in subsequent processing steps;
- Figure 14 shows an enlarged detail of Figure 13;
- Figure 16 is a top plan view of the wafer of Figure 15;
- Figure 17 shows the wafer of Figure 15 in a subsequent processing step;
- Figure 18 is a top plan view of the wafer of Figure 17;
- Figure 19 shows the wafer of Figure 17 in a final fabrication step, wherein ferro-electric memory cells have been made according to the present invention; and
- Figure 20 is a cross-sectional view of the wafer of Figure 19, taken along the line XX-XX of Figure 19.

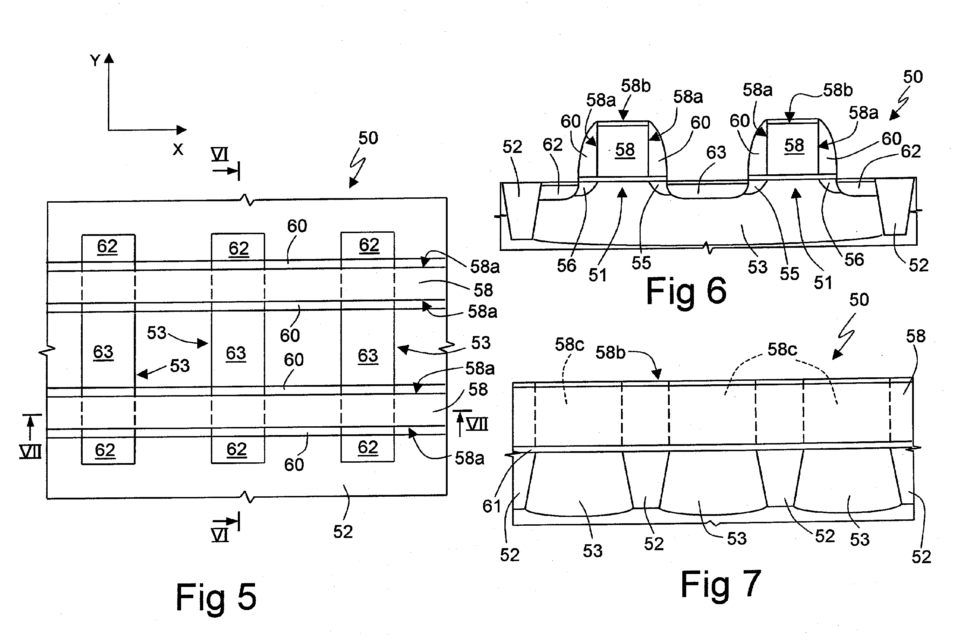

With reference to Figures 5-7, a semiconductor wafer 50 is initially subjected to standard processing steps for making a plurality of selectors 51, which in the example illustrated are NMOS transistors. In greater detail, within the wafer 50 there is made an insulating structure 52 of the trench type (STI, "Shallow Trench Insulation"), which delimits a plurality of semiconductor active areas 53, of a P type, insulated from one another. The active areas 53 are moreover aligned in rows in a first direction X (in the figure active areas 53 belonging to a single row are illustrated). In a way in itself known, in each active area 53 two selectors 51 are then formed through the following steps:
- light ion implantation and subsequent thermal activation, for making drain-extension regions 55 and source-extension regions 56 of an N-type;
- growth of a gate-oxide layer (herein not shown) of predetermined thickness on top of the active area 53;
- deposition and definition of a layer of polycrystalline silicon, to make word lines 58 in relief with respect to the surface of the wafer 50 and parallel to the first direction X (in practice - see Figures 5 and 7 -, the word lines 58 are common to the active areas 53 arranged in a same row, and each active area 53 is overlaid by two respective word lines 58; furthermore - see Figure 6 -, the word lines 58 are arranged between respective drain-extension regions 55 and source-extension regions 56);
- formation of lateral protective elements or spacers 60, made of silicon oxide, along sides 58a of each word line 58, in such a way as to protect the drain-extension regions 55 and source-extension regions 56 (in this step, there is also removed the gate-oxide layer on the outside of the word lines 58 and of the spacers 60; residual portions of the gate-oxide layer form gate-oxide regions 61);
- heavy ion implantation, to form, in each active area 53, two lateral drain regions 62 and a common central source region 63, all of an N⁺ type; and
- silicidation of the exposed conductive regions, in particular of the drain regions 62 and of the source regions 63 and of top faces 58b of the word lines 58.

In practice, the selectors 51 made in the same active area 53 are arranged alongside one another in a second direction Y, perpendicular to the first direction X, and share the same common source region 63. The word lines 58 run on top of selectors 51, aligned in the first direction X and belonging to distinct active areas 53; moreover, the gate electrodes of aligned selectors 51 are formed by respective portions 58c of a same common word line 58 (for reasons of clarity, the portions 58c are delimited by a dashed line in Figure 7). Since the word lines 58 are raised with respect to the drain and source regions 62, 63, at this stage of the manufacturing process the surface of the wafer 50 has relieves formed by the word lines 58 and by the respective spacers 60; in cross section, these relieves have a profile which is laterally curved, and flat on the top.

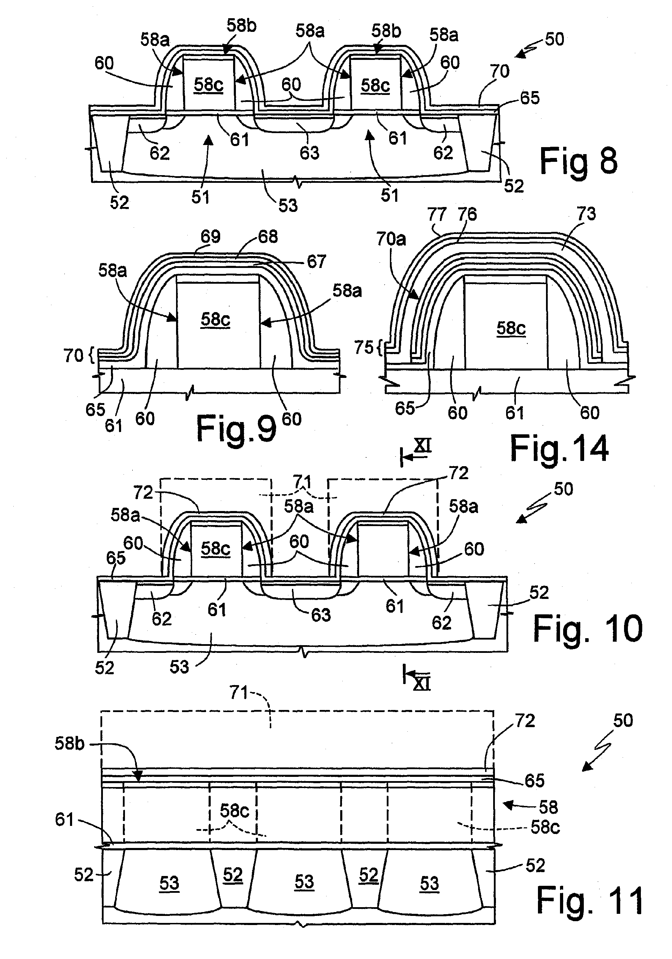

Once the selectors 51 have been completed (Figure 8), an insulating layer 65, preferably of tetra-ethyl orthosilicate (TEOS) having a thickness of between 50 nm and 200 nm, is deposited. The insulating layer 65 coats the entire wafer 50 conformally, following in practice the profile of the relieves (i.e., it is curved above the spacers 60 and flat on the word lines 58).

As illustrated also in the enlargement of Figure 9, a first stack 70 of conductive layers is then deposited, which preferably comprises a TiN layer 67, a first Ir layer 68, and a first IrO₂ layer 69 (for reasons of simplicity, the layers 67-69 are not illustrated separately in Figure 8). Preferably, the TiN layer 67 is made by sputtering or using a metallorganic-chemical-vapour-deposition (MOCVD) process, which enables deposition of conformal layers also on vertical walls; the first Ir layer 68 and the first IrO₂ layer 69 are formed using the MOCVD technique. Furthermore, the deposition of the stack 70 is favoured both by the conformation of the word lines 58 and the spacers 60 and by the excellent properties of adhesion between the TiN layer 67 and the insulating layer 65.

Consequently, also the stack 70 substantially follows the profile of the relieves formed by the word lines 58 and by the respective spacers 60. Furthermore, the stack 70 forms a conductive barrier which, during the subsequent annealing steps described hereinafter, prevents diffusion of the oxygen in the underlying semiconductor and/or metallic regions, thereby preventing their oxidation.

Next, the stack 70 is shaped using a first mask 71, illustrated with a dashed line in Figure 10. In greater detail, the first mask 71 protects the parts of the stack 70 that are inclined and in relief, i.e., on top of the word lines 58 and of the spacers 60. Consequently, the flat parts of the stack 70 remain exposed and are removed during etching, which is stopped on the insulating layer 65. The residual portions of the stack 70 form plate lines 72, which extend parallel to respective word lines 58 and coat them both laterally, i.e., along the sides 58a and the spacers 60, and on the top faces 58b (Figure 11). Consequently, the plate lines 72 have a curved profile in cross section, with side walls 72a ascending along the spacers 60, and a plane top stretch 72b on top of the respective word line 58 (the top stretch 72b could also be absent, if the word lines are narrow: in this case the side walls 72a join up directly with one another).

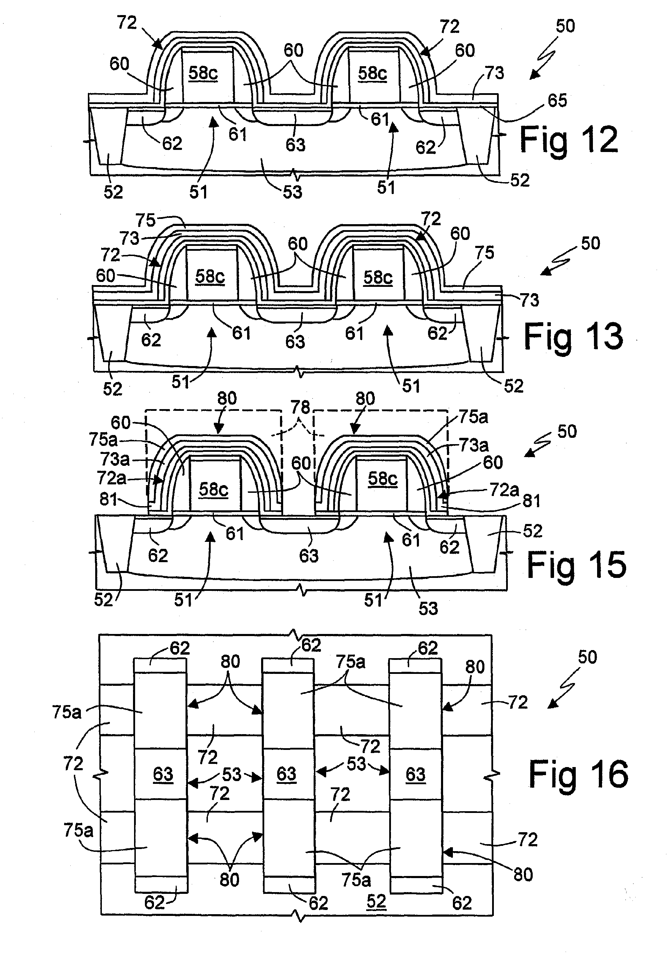

After removal of the first mask 71 (Figure 12), a ferro-electric layer 73, for example made of PZT (PbZrTiO₃) or SBT (SrBi₂Ta₂O₉), is conformally deposited on the wafer 50, preferably again via a MOCVD process.

A process of recrystallization (annealing) in oxygen of the ferro-electric layer 73 is then carried out, to bring the ferro-electric material previously deposited from the amorphous phase to the ferro-electric phase. The annealing process is carried out at a temperature of between approximately 650°C and 750°C (hence relatively low) and has a duration of less than 60 minutes. In addition, during annealing, all the (silicidized) semiconductor regions for which a risk of oxidation could exist, namely, the word lines 58 and the drain and source regions 62, 63, are protected by the plate lines 72 and by the insulating layer 65. As explained previously, in fact, the plate lines 72 are formed by a succession of conductive layers that constitute a barrier to the diffusion of oxygen, thus preventing the underlying polysilicon from being reached. The regions not covered by the plate lines 72 are in any case adequately protected by the insulating layer 65, since annealing is conducted at a relatively low temperature and has a rather short duration. In the conditions indicated above, in particular, the thickness of the insulating layer 65 is such as to prevent diffusion of the oxygen, and hence growth of the insulating layer 65 itself towards the inside of the wafer 50 is altogether negligible (less than 3 nm).

With reference to Figures 13 and 14, after annealing of the ferro-electric layer 73, a second stack 75 is conformally deposited, which comprises, in order, a second IrO₂ layer 76 and a second Ir layer 77 (in Figure 13 the layers 76, 77 are not illustrated separately, for reasons of simplicity).

Then (Figures 15 and 16), a second mask 78 is defined (illustrated hatched in Figure 15), which basically protects the second stack 75 where the plate lines 72 cross the active areas 53, in practice leaving uncovered the plane portions above the drain regions 62 and the source regions 63. The second stack 75, the ferro-electric layer 73 and the insulating layer 65 are then etched in sequence using the second mask 78 and are removed where exposed. In this way, on top of each selector 51 a respective ferro-electric capacitor 80 is obtained. In greater detail, each ferro-electric capacitor 80 comprises a top electrode 75a, formed by a respective residual portion of the second stack 75, a bottom electrode 72a, formed by a portion of the plate lines 72, underlying the respective top electrode 75a, and by a ferro-electric region 73a, arranged between the top electrode 75a and the bottom electrode 72a and formed by a respective residual portion of the ferro-electric layer 73. In practice, the top electrodes 75a and the ferro-electric regions 73a of the ferro-electric capacitors 80 are shaped like curved strips arranged transversely on the plate lines 72 above the active areas 53 and the selectors 51 (and, obviously, on top of the respective bottom electrodes 72a). Consequently, the ferro-electric capacitors 80 surround and cover on three sides, i.e., both on the sides and on top, the portions 58c of the word lines 58 which form the gate electrodes of the respective selectors 51. Furthermore, the ferro-electric capacitors 80 are separated by the word lines 58 laterally, by means of the insulating layer 65 and the spacers 60, and on top, by just the insulating layer 65. Note that the second mask 78 is defined in such a way that, after etching, the margins of the ferro-electric regions 73a rest upon the insulating layer 65, forming feet 81, and the margins of the top electrodes 75a rest on the feet 81. In this way, direct electrical contact between the top electrodes 75a and the respective bottom electrodes 72a is prevented also during the subsequent processing steps. The bottom electrodes 72a of ferro-electric capacitors 80 aligned in the first direction X are in practice formed by a same common plate line 72.

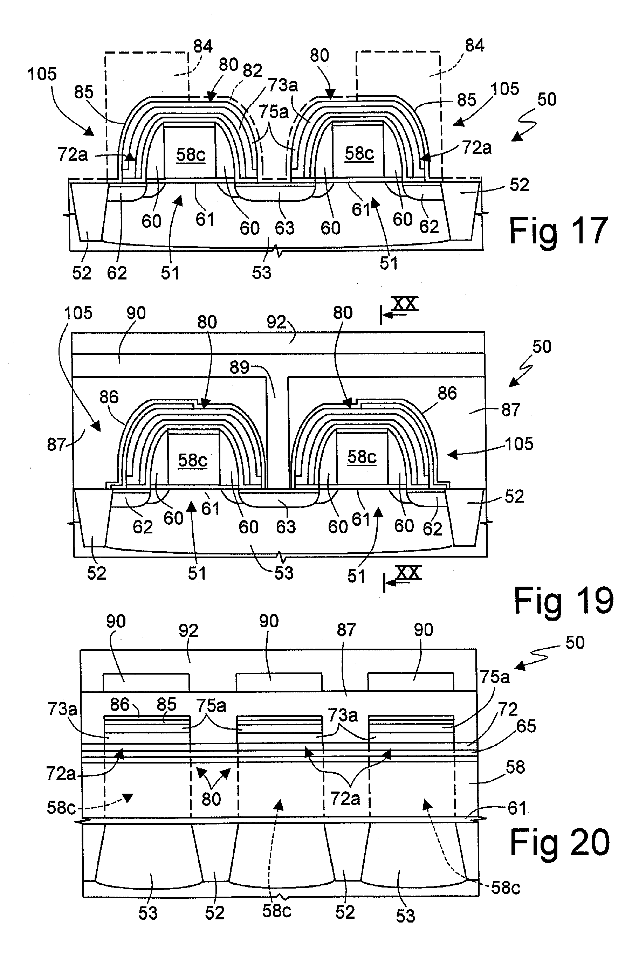

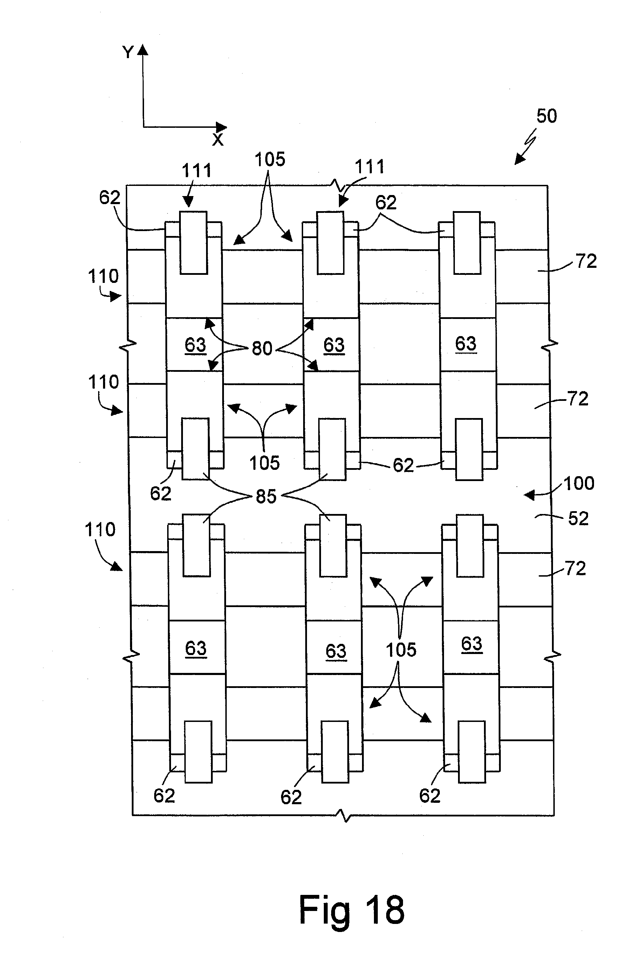

At the end of the etching step of the second stack 75, of the ferro-electric layer 73, and of the insulating layer 65, the drain regions 62 and the source regions 63 are uncovered, except in the vicinity of the respective ferro-electric capacitors 80. After removing the second mask 78 (Figure 17), a contact layer 82, for example made of TiN, is deposited on the wafer 50 and thus adheres directly to the drain regions 62 of the selectors 51, as well as to the source regions 63. The contact layer 82 is then shaped by a third mask 84. In detail, the third mask 84 protects the contact layer 82 above the drain regions 62, extending in part on the insulating structure 52, and above the top electrodes 75a, preferably as far as their vertical median axis; above the remaining portions of the top electrodes 75a and above the source regions, instead, the contact layer 82 is left uncovered and then removed. In this way, drain contacts 85 are made, that partially coat the top electrodes 75a of the ferro-electric capacitors 80 and connect them to the drain regions 62 of the respective selectors 51.

At this stage of the process, in practice, an array 100 of ferro-electric cells 105 is obtained, each of which comprises a respective ferro-electric capacitor 80 and a respective selector 51. The cells 105 are organized in rows 110, parallel to the first direction X, and in columns 111, parallel to the second direction Y; moreover, in each active area 53 of the wafer 50, there are two adjacent cells 110, the selectors of which share the same source region 63.

The process is then completed with standard processing steps. In particular, after deposition of a barrier layer 86 (H-sealing), for example made of alumina (Al₂O₃), so as to protect the ferro-electric capacitors 80, a dielectric layer 87is deposited and planarized by means of CMP, which coats completely the wafer 50. The dielectric layer 87 is then etched so as to open source contacts 89, which reach respective source regions 63. Then, on top of the dielectric layer 87 bit lines 90 are formed, which run perpendicular to the word lines 58 and to the plate lines 72 and are connected to the underlying selectors 51 by the source contacts 89; at the same time, contacts (not shown) are opened also for the word lines 58 and the plate lines 72. Finally, the wafer 50 is coated with a passivation layer 92; in this way, the structure illustrated in Figures 19 and 20 is obtained.

The cells and the manufacturing process thereof described above have several advantages. In the first place, the ferro-electric capacitors 80, owing to their curved shape, have a large surface and high capacitance, against a modest occupation of area (indeed, the encumbrance by the cells 110 is due basically to the selectors 51 rather than to the ferro-electric capacitors 80). In particular, the contribution of the side parts of the ferro-electric capacitors 80, formed up against the spacers 60, is dominant and can be increased by modifying the aspect ratio of the cross section of the word lines 58, without affecting the area occupied by the cell 110. This also favours the scalability of the cells 110 and, obviously, of arrays of cells 110. In practice, it is possible to reduce the thickness of the ferro-electric regions 73a of the ferro-electric capacitors 80 in order to reduce the reading and programming voltages required. The selectors 51 may hence have a smaller channel length, without there occurring phenomena of punch-through, and, accordingly, also the gate electrodes and the word lines 58 can have a smaller width. The capacitance of the ferro-electric capacitors 80 can instead be conserved, albeit with a smaller occupation of area, exploiting their development in height and the contribution of the side parts. Furthermore, for each pair of adjacent cells 110 two through contacts out of three are eliminated (the bottom electrodes 72a are connected by means of the plate lines 72, while the top electrodes 75a are connected to the respective source regions 63 by the drain contacts 85; this enables, among other things, using just one level of metallizations, thus simplifying the construction of the cells 110).

In the second place, the manufacturing process of the cells 110 is much simpler than the known processes and has a greater yield, since some critical steps are removed. On the one hand, in fact, the construction of an entire insulating level is saved, with the corresponding steps of planarization and opening of through contacts, because the ferro-electric capacitors 80 are separated from the selectors 51 and from the word lines 58 only by the insulating layer 65, which is frequently just a few tens of nanometers thick (in addition to the already cited use of a single level of metallizations). On the other hand, annealing of the ferro-electric material is carried out before fabrication of the contacts, when all the semiconductor regions are well protected by the first stack 70 and/or by the insulating layer 65. The risk that conductive parts will be oxidized is hence completely eliminated.

Finally, it is evident that modifications and variations can be made to the device described herein, without departing from the scope of the present invention. For example, a single selector instead of two, and hence a single cell, could be provided in each active area. Furthermore, also the architecture of the memory array could be different.

## Claims

1. A ferro-electric memory cell comprising:
- a ferro-electric capacitor (80), having a first electrode (72a) and a second electrode (75a) and a ferro-electric region (73a) arranged between said first and second electrodes (72a, 75a); and
- a selector (51), associated to said ferro-electric capacitor (80) and having conduction regions (62, 63), formed in an active area (53) of a semiconductor body (50), and a control region (58c), which is raised with respect to said conduction regions (62, 63);
**characterized in that** said ferro-electric capacitor (80) is set adjacent to at least one side (58a, 58b) of said control region (58c).

2. The cell according to Claim 1, wherein said ferro-electric capacitor (80) is arranged adjacent both to sides (58a) and to a top face (58b) of said control region (58c).

3. The cell according to Claim 1 or Claim 2, wherein said capacitor (80) has a curved profile and surrounds said control region (58c) laterally and on top.

4. The cell according to Claim 3, wherein said control region (58c) is provided, on the sides (58a), with protection elements (60), which form with said control region (58) a relief with respect to said active area (53), and in that said ferro-electric capacitor (80) has a substantially conformal profile to said relief.

5. The cell according to any one of the foregoing claims, wherein an insulating layer (65), having a constant thickness comprised between 50 nm and 200 nm, is arranged between said ferro-electric capacitor (80) and said control region (58c).

6. The cell according to Claim 5, wherein said insulating layer is directly in contact with said first electrode of said ferro-electric capacitor (80) and at least in part with said control region (58c).

7. The cell according to any one of the foregoing claims, comprising a contact (85) that coats at least partially said second electrode (75a) and connects said second electrode (75a) to a first of said conductive regions (62).

8. The cell according to any one of the foregoing claims, wherein said first electrode (72a) is a bottom electrode and said second electrode (75a) is a top electrode.

9. A memory array, comprising a plurality of cells (105) arranged in rows (110), according to a first direction (X), and in columns (111), according to a second direction (Y), cells (105) arranged on a same row being connected by means of a common word line (58) and a common plate line (72); wherein said cells are made according to any one of Claims 1 to 8.

10. The memory array according to Claim 9, comprising a plurality of active areas (53), and wherein in each of said active areas (53) two selectors (51) associated to adjacent cells (105) are housed.

11. The memory array according to Claim 9 or Claim 10, wherein said control regions (58a) of selectors (51) arranged in a same row (105) are formed by respective portions of a same said common word line (58).

12. The memory array according to any one of Claims 9-11, wherein said first electrodes (72a) of said ferro-electric capacitors (80) arranged in a same row (105) are formed by respective portions of a same said common plate line (72) overlying said active areas (53).

13. The array according to Claim 12, wherein said second electrodes (75a) of said ferro-electric capacitors (80) are formed as respective strips arranged transversely to said plate lines (72) on top of respective said first electrodes (72a).

14. A method for the fabrication of ferro-electric memory cells (105), comprising the steps of:
- forming, in a semiconductor body (50), at least one active area (53);
- forming a selector (51), having conduction regions (62, 63), embedded in said active area (53), and a control region (58c), raised with respect to said conduction regions (62, 63); and
- forming a ferro-electric capacitor (80), having a first electrode (72a) and a second electrode (75a) and a ferro-electric region (73a) set between said first electrode (72a) and second electrode (75a);
**characterized in that** said step of forming a ferro-electric capacitor comprises the steps of depositing at least one first conductive layer (67-70), a ferro-electric layer (73), and a second conductive layer (75-77) substantially in a conformal way on said control region (58c), so as to cover said control region (58c) on at least one side (58a, 58b).

15. The method according to Claim 14, wherein said step of depositing comprises covering both sides (58a) and a top face (58b) of said control region (58c).

16. The method according to Claim 14 or Claim 15, wherein said step of forming a ferro-electric capacitor comprises shaping said first conductive layer (67-70), said ferro-electric layer (73) and said second conductive layer (75-77) so as to form, respectively, said first electrode (72a), said ferro-electric region (73a), and said second electrode (75a).

17. The method according to Claim 16, wherein said first conductive layer (67-70) is shaped using a first mask (71), and said ferro-electric layer (73) and said second conductive layer (75-77) are shaped using a second mask (78).

18. The method according to any one of Claims 14-18, wherein an insulating layer (65), having a uniform thickness comprised between 50 nm and 200 nm, is deposited conformally on said control region (58c), before depositing said first conductive layer (76-70).

19. The method according to Claims 14 to 18, wherein a step of annealing of said ferro-electric layer (73) is carried out.

20. The method according to Claim 19, wherein said step of annealing is carried out at a temperature of between 650°C and 750°C and has a duration of less than 60 minutes.

21. The method according to Claim 19 or Claim 20, wherein, after said step of annealing, a contact (85) is made between said second electrode (75a) and a first of said conductive regions (62).

22. The method according to Claim 21 as attached to Claim 18, wherein said step of making a contact comprises:
- removing said insulating layer (65) on top of said first of said conductive regions (62);
- depositing a third conductive layer (82) conformally directly on top of said second electrode (75a) and in contact with said first of said conductive regions (62); and
- shaping said third conductive layer (82).
